# EUROPÄISCHE PATENTSCHRIFT

(11) **EP 1 715 076 B1**
(45) Veröffentlichungstag und Bekanntmachung des Hinweises auf die Patenterteilung: **22.07.2009**
(21) Anmeldenummer: 05008663.6
(22) Anmeldetag: 20.04.2005
(51) Int. Cl.: C23C 14/04

(54) **Verfahren und Vorrichtung zur Maskenpositionierung**
Method and apparatus for positioning a mask
Procédé et appareil de positionnement d'un masque

(43) Veröffentlichungstag der Anmeldung: 25.10.2006
(73) Patentinhaber: Applied Materials GmbH & Co. KG, 63755 Alzenau (DE)
(72) Erfinder: Manz, Dieter, 72141 Walddorfhäslach (DE)
(74) Vertreter: Lang, Christian

(56) Entgegenhaltungen:
- DE-A1- 10 132 348
- PATENT ABSTRACTS OF JAPAN Bd. 1999, Nr. 11, 30. September 1999 (1999-09-30) -& JP 11 158605 A (ANELVA CORP), 15. Juni 1999 (1999-06-15)
- PATENT ABSTRACTS OF JAPAN Bd. 2003, Nr. 11, 5. November 2003 (2003-11-05) -& JP 2003 187973 A (ANS INC), 4. Juli 2003 (2003-07-04)
- PATENT ABSTRACTS OF JAPAN Bd. 1998, Nr. 11, 30. September 1998 (1998-09-30) -& JP 10 152776 A (TORAY IND INC), 9. Juni 1998 (1998-06-09)
- PATENT ABSTRACTS OF JAPAN Bd. 2003, Nr. 12, 5. Dezember 2003 (2003-12-05) -& JP 2004 047238 A (ANS INC), 12. Februar 2004 (2004-02-12)

## Beschreibung

Die vorliegende Erfindung betrifft ein Verfahren bzw. eine Vorrichtung zum Anordnen/Entfernen und Ausrichten von Masken auf zu beschichtenden Substraten, insbesondere zur Mikrostrukturierung von organischen elektrolumineszierenden Materialien (OLED) auf vorzugsweise großflächigen Substraten, insbesondere Bildschirmen, Displays und dergleichen im Vakuum.

Bei der Herstellung von so genannten OLED-Displays oder -Bildschirmen, die die Licht emittierenden Eigenschaften von organischen, elektrolumineszierenden Materialien (OLED) nutzen, ist es erforderlich, die organischen elektrolumineszierenden Materialien mit einer entsprechenden Mikrostrukturierung auf einem transparenten Substrat, wie beispielsweise Glas aufzubringen, so dass über entsprechende Elektrodenschichten die elektrolumineszierenden Strukturen angesteuert und zur Lichtabgabe angeregt werden können.

Die Aufbringung der mikrostrukturierten, organischen, elektrolumineszierenden Materialien erfolgt üblicherweise durch Vakuumbeschichtungsprozesse, wobei zur Erzeugung der Mikrostruktur entsprechende Schattenmasken eingesetzt werden. Diese Maske müssen in geeigneter Weise auf die Substrate aufgesetzt, mit diesen durch die entsprechenden Beschichtungskammern transportiert und dann von den Substraten wieder abgenommen werden, um nach einer eventuellen Reinigung wieder erneut eingesetzt zu werden.

Aufgrund der geringen Dimensionen der Mikrostrukturierung kommt es hierbei auf eine sehr genaue Positionierung der Masken an, insbesondere wenn so genannte RGB-Displays hergestellt werden, bei denen für die bunte Darstellung auf dem Display eng benachbart zueinander Pixelbereiche für rotes, grünes und blaues Licht erzeugt werde müssen. Darüber hinaus erfordern die Vakuumbeschichtungsprozesse einen hohen Grad an Reinheit, so dass durch die Handhabungseinrichtungen für die Masken gewährleistet sein muss, dass keine unnötigen Partikel erzeugt werden.

Aus dem Stand der Technik ist eine Magnethalterung für Folienmasken bekannt (DE 297 07 686 U1), bei der auf einem Substratträger über Fixierstifte eine Folienmaske angeordnet wird, auf der dann wiederum das zu beschichtende Substrat zu liegen kommt. Über dem Substrat wird dann eine Magnetanordnung vorgesehen, die dazu dient, die ferromagnetische Maske vollflächig gegen das Substrat zu drücken, das zwischen Maske und Magnetanordnung vorgesehen ist. Bei einer derartigen Ausgestaltung einer Maskenhalterung wird durch die mechanische Befestigung der Maske auf dem Substratträger die Erzeugung von unerwünschten Partikeln begünstigt und zudem ist eine derartige Anordnung ungünstig für eine einfache, schnelle und präzise Anordnung und Entfernung der Maske von dem Substrat.

Ferner ist aus der EP 1 202 329 A2 eine Maskenanordnung bekannt, bei der eine Maske durch eine hinter dem Substratträger angeordneten Magnetanordnung vollflächig gegen das Substrat gedrückt wird. Die dort beschriebenen Masken können einen umlaufenden Rahmen aufweisen, durch den die Maske seitlich verspannt wird, um der dünnen Folie, aus der die Maske üblicherweise gefertigt ist, eine gewisse Stabilität zu verleihen. Obwohl mit einer derartigen magnetischen Anziehung der Maske gegen das Substrat eine vollflächige Anlage der Maske an dem Substrat und somit Blasenfreiheit und scharfe Beschichtungskanten erzielt werden, ist eine derartige Anordnung für die schnelle und präzise Handhabbarkeit in Bezug auf Maskenwechsel, insbesondere unter Vakuumbedingungen, nicht optimal. Außerdem dienen die Magnete lediglich zum vollflächigen, blasenfreien Anlegen der Maske an das Substrat, jedoch nicht für Halterung in einem dynamischen System, in dem das Substrat auf dem Substratträger mit der Maske durch den Beschichtungsbereich bewegt wird.

Weitere Vorrichtungen und Verfahren zur Anordnung von Masken auf zu beschichtenden Substraten sind aus den japanischen Dokumenten JP 11158605 A, JP 2003187973 A und JP 10152776 A bekannt. Bei diesen bekannten Vorrichtungen und Verfahren wird die Übergabe der Maske auf das Substrat lediglich durch Bewegung der Halteanordnung der Maske bewirkt bzw. es wird eine vollflächige Anlage der Maske an das Substrat durch über die gesamte Fläche des Substrats verteilte Haltemagnete bewirkt. Außerdem betreffen diese Vorrichtungen und Verfahren zum Teil lediglich stationäre Beschichtungsvorrichtungen, so dass die besonderen Anforderungen im Hinblick auf dynamische Vakuumbeschichtungsgprozesse für die In-Line-Herstellung nicht berücksichtigt werden.

Insgesamt erzielen die bekannten Vorrichtungen und Verfahren nicht die erforderliche Schnelligkeit des Maskenwechsels für In-Line-Prozesse bei entsprechend hoher Positioniergenauigkeit.

Es ist deshalb Aufgabe der vorliegenden Erfindung, ein Verfahren und eine Vorrichtung zum Maskenwechsel, insbesondere zur Anordnung und Ausrichten bei dynamischen Vakuumbeschichtungsprozessen für die In-Line-Herstellung von OLED-Bildschirmen oder - Displays bereit zu stellen, bei denen die Nachteile des Standes der Technik vermieden und insbesondere eine präzise, schnelle und einfache Möglichkeit des Maskenwechsels sowie eine sichere und zuverlässige Anordnung der Maske an dem während der Beschichtung bewegten (dynamischen) Substrat gewährleistet ist. Insbesondere sollen die entsprechenden Vorrichtungen für die Maskenwechsel einfach herstellbar und einfach zu bedienen sein.

Diese Aufgabe wird gelöst durch ein Verfahren mit den Merkmalen des Anspruchs 1 sowie eine Vorrichtung mit den Merkmalen der Ansprüche 7 oder 8. Vorteilhafte Ausgestaltungen sind Gegenstand der abhängigen Ansprüche.

Die vorliegende Erfindung beruht nach einem ersten Aspekt auf der Erkenntnis, dass die Handhabung der Maske, insbesondere im Vakuum, vorteilhaft durch Elektromagneten realisiert werden kann, die ein- und ausgeschaltet werden können, so dass damit in einfacher Weise eine entsprechende Kraft auf die Masken ausgeübt und wieder abgeschaltet werden kann. Aus diesem Grunde ist eine Vorrichtung geschaffen worden, bei der eine erste Bewegungseinrichtung und eine Halteanordnung vorgesehen sind, wobei die Halteanordnung die Maske aufnehmen und wieder absetzen kann, während die erste Bewegungseinrichtung zur Ausrichtung der Maske bezüglich des Substrats vorgesehen ist. Erfindungsgemäß weist die Halteanordnung Elektromagnete auf, mit denen eine magnetische Maske bzw. eine Maske mit magnetischem Rand oder Rahmen in einfacher Weise aufgenommen und wieder abgesetzt werden kann. Die Elektromagneten sind hierbei vorzugsweise an einer Halteplatte oder einem Halterahmen umlaufend um einen elektromagnetfreien Zentralbereich angeordnet, so dass die Maske an ihrem Rand bzw. an ihrem umlaufenden Rahmen aufgenommen werden kann. Dies hat zum einen den Vorteil, dass eine sichere und stabile Aufnahme der Maske in der Maskenanordnungs- und -positioniereinrichtung bei geringer Anzahl von Elektromagneten gewährleistet ist und zum anderen können viele unterschiedliche Masken gehandhabt werden, da für nicht magnetische Masken lediglich ein entsprechender magnetischer Rahmen vorgesehen werden muss.

Vorzugsweise sind die Elektromagnete ringförmig, rechteckförmig oder mehreckig in einem geschlossenen Band äquidistant zueinander angeordnet, so dass eine gleichmäßige Aufnahme der Maske erfolgen kann.

Die Bewegungseinrichtung, die es ermöglicht, die Halteanordnung relativ zum Substrat zu bewegen, umfasst vorzugsweise mehrere unabhängige Bewegungsmittel, insbesondere Bewegungsmittel in mindestens drei unabhängigen Bewegungsrichtungen. Vorzugsweise sind die Bewegungsmittel durch Linearantriebe und/oder Drehantriebe gebildet, die einerseits entlang der drei zueinander senkrechten Raumrichtungen, also den x-/y-/z-Koordinaten entsprechende Bewegungen der Halteanordnung und/oder andererseits Rotationsbewegungen ermöglichen.

Nach einem weiteren Aspekt der Erfindung, für den auch unabhängig Schutz begehrt wird, ist eine zweite Bewegungseinrichtung vorgesehen, die unabhängig von der ersten Bewegungseinrichtung die Annäherung des Substrats an die Maske ermöglicht.

Zu diesem Zweck weisen vorzugsweise sowohl die zweite Bewegungseinrichtung als auch der Substratträger entsprechende Kopplungsmittel auf, die ein Verbinden und Lösen in einfacher Weise ermöglichen.

Nach einer bevorzugten Ausführungsform umfasst die zweite Bewegungseinrichtung mehrere Bewegungsmittel, insbesondere Linearantriebe.

Durch die Entkopplung von Ausrichtung der Maske bezüglich des Substrats und Annäherung von Substrat and Maske kann insbesondere im Zusammenhang mit der magnetischen Übergabe und Halterung während der dynamischen Beschichtung eine besonders exakte und saubere Maskierung erreicht werden.

Vorzugsweise sind für die Bewegungen der Haltanordnung bzw. der Maske insbesondere in Richtung zum Substrat und von diesem weg bzw. umgekehrt für die Bewegung des Substrats zur Maske und von dieser wieder weg Spindelantriebe vorgesehen, die eine besonders sanfte, ruckfreie und gleichmäßige Bewegung ermöglichen.

Zur Steuerung der Bewegungseinrichtung ist vorzugsweise eine Überwachungs- und/oder Steuereinrichtung vorgesehen, wobei die Überwachungseinheit die Fehlpositionierung der Maske bezüglich des Substrats feststellt und die entsprechende Steuereinheit durch Ansteuerung der ersten Bewegungseinrichtung eine entsprechende Korrektur vornehmen kann. Für diesen Zweck weist die Überwachungseinheit vorzugsweise mindestens zwei CCD-Kameras auf, die entsprechende Markierungsmarken am Substrat und an der Maske in Übereinstimmung bzw. Überdeckung bringen.

Da der Maskenwechsel vorzugsweise im Vakuumbereich der Vakuumbeschichtungsanlage stattfindet, ist die Vorrichtung vorteilhafter Weise so ausgestaltet, dass sie an einer Vakuumkammerwand anordenbar ist, wobei vorzugsweise der oder die Antriebe der Bewegungseinrichtungen oder zumindest von Teilen der Bewegungsmittel außerhalb der Vakuumkammer angeordnet ist, um die Einbringung von Verunreinigungen in den Vakuumbereich zu verringern.

Vorzugsweise ist die Vorrichtung für den Maskenwechsel derart gestaltet, dass für die Substratträger eine Substratträgerhalteposition bereitgestellt wird, die so vordefiniert ist, dass bereits eine Vorpositionierung des Substrats gegenüber der Maske stattgefunden hat.

Ferner weist der Substratträger vorzugsweise Magnete, nämlich Permanentmagnete oder Elektromagnete auf, die die Maske während des Beschichtungsprozesses auf oder in Bezug zu dem Substrat halten. Da hierbei in vorteilhafter Weise Masken mit magnetischem Rand oder Rahmen verwendet werden, sind die Magnete des Substratträgers in entsprechender Weise zu der Halteanordnung umlaufend um den Substrataufnahmebereich angeordnet, so dass bei der Übergabe der Maske von der Halteanordnung an den Substratträger und umgekehrt, die Maske in denselben Bereichen, wenn auch auf gegenüberliegenden Seiten gehalten wird.

Zur Anordnung der Magnete am Substratträger weist dieser in vorteilhafter Weise einen Maskenhalterahmen auf, an dem die Magnete gegenüberliegend zum Substrat auf der Rückseite des Substratträgers angeordnet sind.

Bei einer bevorzugten Ausführungsform sind die Magnete an dem Substratträger und die Elektromagnete an der Halteanordnung so aufeinander abgestimmt, dass sie bei der Übergabe genau übereinander angeordnet sind, so dass durch eine entsprechende Magnetfeldüberlagerung die Haltewirkung der Magnete des Substratträgers verringert oder ausgeschaltet werden kann.

Vorzugsweise weist die Halteanordnung der Übergabevorrichtung eine Halteplatte bzw. einen rechteckigen, mehreckigen oder ringförmigen Halterahmen auf, der es beispielsweise ermöglicht, dass im Zentralbereich die CCD-Kameras der Überwachungseinheit einen freien Blick auf die Maske erhalten.

Die Übergabe der Maske erfolgt dann in der Weise, dass zunächst ein Substrat auf einem Substratträger, bei dem vorzugsweise Magnete äquidistant beabstandet zueinander umlaufend um den Substrataufnahmebereich angeordnet sind, in einer Substratträgerhalteposition gegenüberliegend der Maskenhalteanordnung bereit gestellt wird. Die Maske wird vorher, gleichzeitig oder nachfolgend an den Elektromagneten der verfahrbaren Halteanordnung angeordnet und die Überwachungs- und Steuereinrichtung ermittelt die relative Position zwischen Maske und Substrat, insbesondere bezüglich der lateralen Position, also im Hinblick auf die beispielsweise x-/y-Koordinaten einer horizontalen Ebene bei einem horizontalem Transport des Substrats durch die Beschichtungsanlage. Bei Feststellung einer Fehlorientierung bzw. Fehlpositionierung wird eine Ausrichtung von Substrat und Maske durch Betätigung der ersten Bewegungseinrichtung, also vorzugsweise durch Bewegung der Maske vorgenommen, wobei auch eine Bewegung des Substrats denkbar wäre. Die Ausrichtung erfolgt beispielsweise durch Translations- oder Linearbewegungen in zwei senkrecht zueinander liegenden Richtungen, z.B. x-y-Richtung, und/oder eine Drehbewegung um eine weitere senkrechte Achse (z-Achse). Zusätzlich können weitere Bewegungsrichtungen und/oder arten vorgesehen sein, z.B. eine Linearbewegung in z-Richtung.

Nach entsprechender Ausrichtung wird die Maske auf dem Substrat abgelegt, und zwar vorzugsweise durch Betätigung der zweiten Bewegungseinrichtung, so dass Maske und Substrat aufeinander zu bewegt werden. Hierbei ist klar, dass die Bewegung von Maske und Substrat bezüglich gegenseitiger Annäherung und Ausrichtung auch getauscht werden können.

Sobald die Maske auf dem Substrat angeordnet ist, werden die Elektromagnete der Halteanordnung deaktiviert und die Maske wird durch die Magnete des Substratträgers auf dem Substrat gehalten. Das mit der Maske versehene Substrat steht dann auf dem Substratträger für den Transport durch die Beschichtungsanlage und entsprechende Beschichtung bereit. Selbstverständlich kann die Maske durch dieselbe Vorrichtung auch wieder vom Substrat bzw. Substratträger abgenommen werden, wobei hierbei auf eine entsprechende Ausrichtung selbstverständlich verzichtet werden kann.

Weitere Vorteile, Kennzeichen und Merkmale der vorliegenden Erfindung werden bei der nachfolgenden detaillierten Beschreibung eines Ausführungsbeispiels anhand der beigefügten Zeichnungen deutlich. Die Zeichnungen zeigen hierbei rein schematisch in
- Fig. 1: eine Seitenansicht einer Maskenaufbringungsstation, mit der Maske in abgehobenem Zustand;
- Fig. 2: die Maskenaufbringungsstation aus Fig. 1 mit am Substrat angeordneter Maske;
- Fig. 3: die Maskenaufbringungsstation der Fig. 1 und Fig. 2 mit auf dem Substrat abgesetzter Maske; und in
- Fig. 4: eine Draufsicht auf eine Maske mit Rahmen.

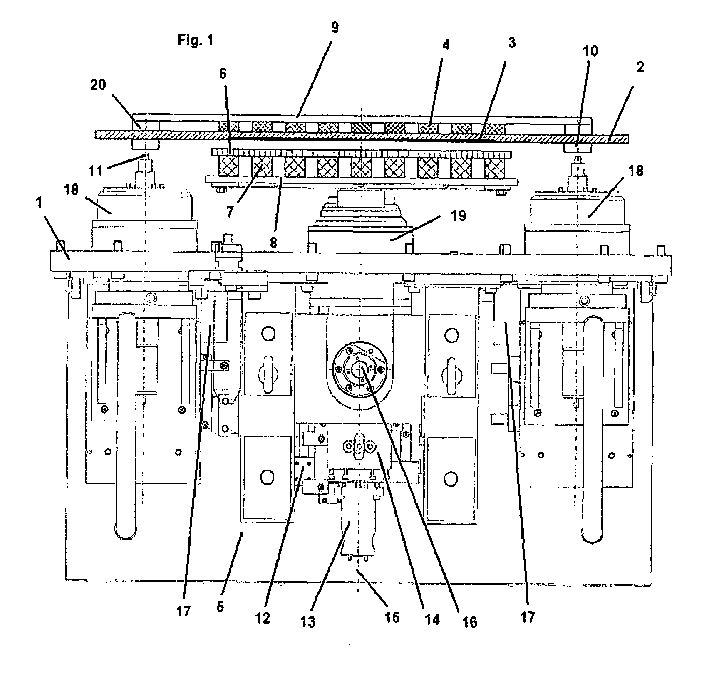

Die Fig. 1 zeigt in einer Seitenansicht und teilweisen Querschnittsansicht eine Maskenaufbringungsstation für eine Vakuumkammer einer Vakuumbeschichtungsanlage, insbesondere für die kontinuierliche (In-Line-) Beschichtung von transparenten Substraten mit organischen, elektrolumineszierenden Materialien für die Herstellung von OLED-Displays bzw. -Bildschirmen oder -Anzeigen.

Die Fig. 1 zeigt einen Schnitt durch eine Kammerwand oder eine Montageplatte 1, die in die Kammerwand einsetzbar ist, wobei in der Vakuumkammer, also oberhalb der Montageplatte 1 der Fig. 1, ein Substratträger 2 mit einem darauf angeordneten Substrat 3 dargestellt ist, der durch nicht dargestellte Transport- bzw. Fördereinrichtungen durch die Vakuumkammer transportiert werden kann.

In dem in Fig. 1 dargestellten Zustand befindet sich das Substrat oberhalb einer Maskenaufbringungsstation mit einer Maskenpositioniereinrichtung 5, mit deren Hilfe die Maske 6 auf dem Substrat 3 angeordnet und ausgerichtet werden kann.

Die Maskenpositioniereinrichtung 5 weist eine Vielzahl von Elektromagneten 7 auf, die umlaufend um eine Halteplatte oder -rahmen 8 angeordnet sind. Der Halterahmen 8 ist wiederum über eine vakuumdichte Führung 19 mit verschiedenen Antrieben 12, 13, 14 und 16 verbunden, die eine Bewegung der Halteplatte bzw. des -rahmens 8 bezüglich des Substratträgers 2 bzw. des Substrats 3 ermöglichen. Dabei erlaubt der Horizontalantrieb 12 eine Bewegung in horizontaler Richtung, der Vertikalantrieb 16 in vertikaler Richtung, also aus der Bildebene heraus, und der Axialantrieb 13 in axialer Richtung, also in Richtung der Achse 15. Zusätzlich ist ein Drehantrieb 14 vorgesehen, der eine Drehung der Halteplatte 8 um die Achse 15 erlaubt. Auf Grund der Antriebe 12, 13, 14 und 16 kann somit die Halteplatte 8 in jede beliebige Position bezüglich des Substratträgers 2 gebracht werden.

Neben der Maskenpositioniereinrichtung 5 ist eine zweite Bewegungseinrichtung in Form von vorzugsweise mehreren, im Ausführungsbeispiel insgesamt vier, zum Ergreifen der Ecken des rechteckigen Substratträgers in einem Viereck angeordneten Hubeinrichtungen 18 vorgesehen. Die Hubeinrichtungen 18 weisen an ihren Enden jeweils Kopplungselemente 11 auf, die mit Substratträgerkopplungen 10 zusammen wirken, so dass der Substratträger 2 mit den Hubeinrichtungen 18 so verbunden werden kann, dass diese den Substratträger 2 bewegen können.

Der Hubmechanismus bzw. -antrieb 18 kann einen hydraulischen oder pneumatischen Hubzylinder oder, wie im bevorzugten Ausführungsbeispiel, auch einen Spindelantrieb umfassen, der durch eine besonders gleichmäßige, exakte und ruckfreie Bewegung ausgezeichnet ist. In gleicher Weise kann auch der Axialantrieb 13 oder die anderen Antriebe ausgebildet sein.

Neben den Hubantrieben 18 und der Maskenpositioniereinrichtung 5 sind an der Montageplatte 1 noch zusätzlich CCD-Kameras 17, vorzugsweise mindestens zwei Kameras vorgesehen, die über jeweils ein Fensterelement die Positionierung der Maske 6 auf dem Substrat 3 überwachen können. Die CCD-Kameras bilden eine Überwachungseinheit, die die exakte Positionierung der Maske zum Substrat überprüfen. Bei einer Fehlstellung wird eine Steuerungseinheit (nicht gezeigt) aktiviert, die die Bewegung der Maskenpositioniereinrichtung 5 steuert. Durch die Antriebe 12, 14 und 16 kann die Maske 6 exakt positioniert werden, da damit eine Ausrichtung des Halterahmens 8 in zwei zueinander senkrechten Richtungen sowie eine Rotation möglich ist. Darüber hinaus ermöglicht der Axialantrieb 13 eine Positionsanpassung bezüglich des Abstands der Maske 6 zum Substrat 3. Insgesamt ergibt sich somit mit der Maskenpositioniereinrichtung 5 die Möglichkeit einer exakten Positionierung der Maske in drei unabhängige Raumrichtungen.

Der Substratträger 2 umfasst umlaufend um den Bereich, in dem das Substrat 3 zu liegen kommt, eine Vielzahl von Magneten 4, die in ihrer Lage mit den Elektromagneten 7 korrespondieren. Dies bedeutet, dass bei Einhaltung der vorgesehen Substrat- und Maskenpositionen die Elektromagnete 7 und die Magnete 4 des Substratträgers 2 bei der Übergabe der Maske an das Substrat 3 einander genau gegenüber liegen bzw. ihre Längsachsen auf einer Achse angeordnet sind. Die Magnete 4 können sowohl Permanentmagnete als auch Elektromagnete sein. Die Magnete 4 sind an der Rückseite des Substratträgers 2 an einem Maskenhalterahmen 9 angeordnet, der wiederum über Abstandshalter 20 an der Substrathalteplatte des Substratträgers 2 angeordnet ist. Der Maskenhalterahmen 9 kann hierbei in jeder geeigneten Weise an der Substrathalteplatte des Substratträgers 2, insbesondere lösbar befestigt sein.

Der Maskenhalterahmen 9 kann sowohl als ringförmiger Rahmen als auch als durchgehende Platte ausgebildet sein. Insbesondere dient der Maskenhalterahmen auch als Magnetjoch für die daran angeordneten Magnete 4.

Die ring- oder rahmenartige Anordnung der Magnete 4,7 um oder entlang des Randes des Aufnahmebereichs für das Substrat 3 bewirkt, dass eine gleichmäßige und für die dynamische Beschichtung ausreichend feste Halterung der Maske 6 mit für die Handhabung ausreichend großen Magnetkräften ohne Beschädigung der dünnen, folienartigen Masken erfolgt.

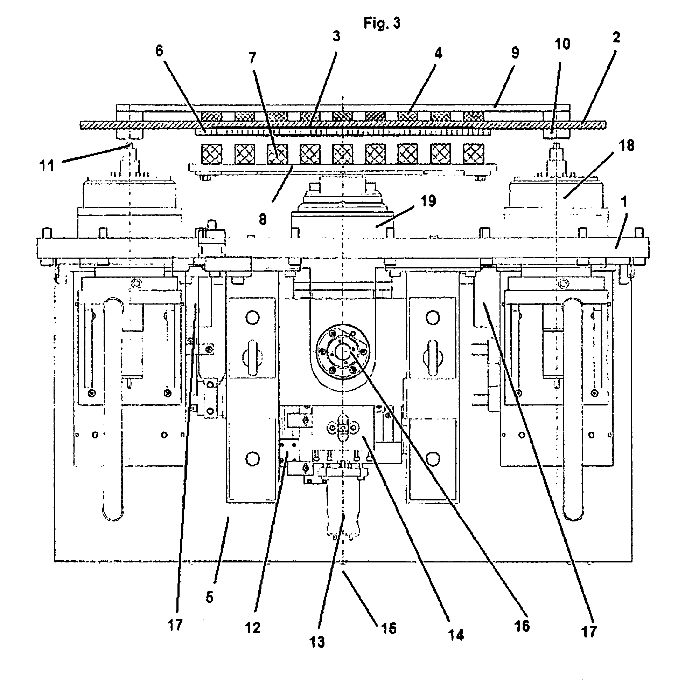

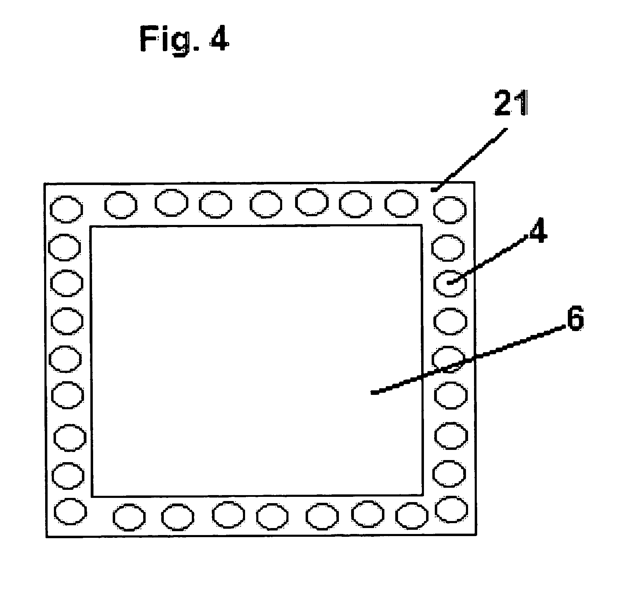

Die Übergabe der Maske an das Substrat erfolgt gemäß der Darstellungen der Figuren 1 bis 3 in der Weise, dass die Maske 6 zunächst von einer Maskenzuführung an die Maskenpositionieranordnung 5 übergeben wird, wobei die Maske 6 einen umlaufenden magnetischen Rahmen oder Rand 21 (siehe Fig. 4) aufweist, der mit den umlaufenden bzw. ringförmig angeordneten Elektromagneten an dem Halterahmen 8 der Maskenpositioniereinrichtung 5 korrespondiert, so dass die Maske 6 über ihren Rahmen 21 oder Rand durch die Elektromagnete 7 der Halteplatte 8 bei entsprechender Aktivierung der Elektromagnete 7 gehalten werden kann.

Sobald das Substrat 3, auf dem die Maske 6 angeordnet werden soll, in einer entsprechend vordefinierten Position gegenüber der Maskenpositioniereinrichtung 5 angeordnet ist, wird über die Antriebe 12,14 und 16 unter Zuhilfenahme der CCD-Kameras 17 die exakte laterale Ausrichtung der Maske 6 zum Substrat 3, also die Ausrichtung in Bezug auf die x-/y-Koordinaten, eingestellt.

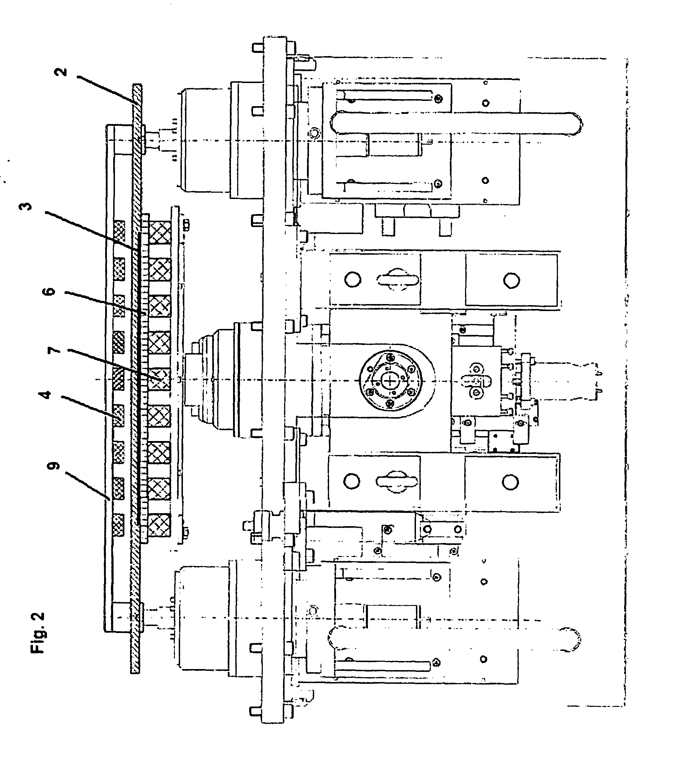

Wenn die Maske 6 in der richtigen Lage oberhalb des Substrats 3 ausgerichtet ist, also in der Projektion Deckungsgleichheit erzielt ist, wird der Substratträger 2 mit dem Substrat 3 durch die Kopplungselemente 11 der Hubeinrichtungen 18 an der Substratträgerkopplung 10 ergriffen und, wie in Fig. 2 dargestellt, mittels der Hubeinrichtungen 18 von hinten an die Maske 6 heran gefahren, so dass der magnetische Rahmen oder Rand der Maske 6 über den Magneten 4 des Substratträgers sowie die Maske 6 über dem Substrat 3 zu liegen kommen. Zusätzlich oder alternativ kann die Bewegung senkrecht zur Substrat- oder Maskenebene auch vom Axialantrieb 13 bewirkt werden.

Danach werden die Elektromagnete 7 deaktiviert bzw. ausgeschaltet und das Substrat 3 mittels der Hubantriebe 18 nach oben weggefahren.

Das Substrat 3 steht dann mit der Maske 6 für den Weitertransport durch die Vakuumbeschichtungsanlage bereit, wobei die Maske 6 über den Rahmen 21 bzw. Rand auf dem Substrat 3 durch die Magnete 4 des Substratträgers 2 gehalten ist.

Dies wird insbesondere in der Draufsicht der Fig. 4 deutlich, welche die Maske 6 und den Rahmen oder Rand 21 der Maske 6 sowie die Magnete 4 zeigt, die sich unterhalb des Rahmens oder Randes 21 auf dem darunter angeordneten Substratträger 2 (nicht gezeigt) befinden. Die gewählte Anordnung der Maskenhalterung über Magnete 4 am Substratträger, insbesondere in einer ring- oder rahmenförmigen Anordnung um oder entlang des Randes des Substrats und das entsprechende Vorsehen eines Rahmens bzw. Randes an der Maske zum Zusammenwirken mit den Magneten, ermöglichen eine einfache Handhabung der Maske, eine sichere Halterung der Maske am Substrat bzw. Substratträger während der dynamischen Beschichtung sowie eine wesentliche Reduzierung der entstehenden Partikel bei der Handhabung der Maske, also dem Auf- und Absetzen der Maske. Ferner ist eine kostengünstige Konstruktion und Ausführung des Gesamtssystems ermöglicht.

Durch die Verwendung von Elektromagneten zum Aufnehmen und Absetzen bzw. Halten der Maske an ihrem Rahmen bzw. Rand in der Positioniereinrichtung ist eine einfache Übergabe gewährleistet, wobei insbesondere bei Verwendung eines Spindelantriebs zur Höhenverstellung der Positioniereinrichtung und/oder der Hubeinrichtungen für den Substratträger eine besonders gleichmäßige und ruckfreie Bewegung und Übergabe erzielt werden kann. Die Maske 6 und der Rahmen 20 können sowohl einstückig als auch mehrteilig ausgebildet sein, wobei bei mehrteiligen Ausführungen von einem Rahmen gesprochen wird, während bei einstückiger Ausführung von einem Rand die Rede ist.

Obwohl hier nur die Anordnung der Maske auf dem Substrat beschrieben ist, ist selbstverständlich auch die Abnahme der Maske vom Substrat mit der gleichen Vorrichtung in umgekehrter Weise möglich. Lediglich die Ausrichtung der Maske kann entsprechend entfallen.

### Bezugszeichenliste:

- 1: Kammerwand
- 2: Substratträger
- 3: Substrat
- 4: Magnete
- 5: Maskenpositioniereinrichtung
- 6: Maske
- 7: Elektromagnete
- 8: Halteplatte bzw. -rahmen
- 9: Maskenhalterahmen
- 10: Substratträgerkopplung
- 11: Greifeinrichtung
- 12: Horizontalantrieb
- 13: Axialantrieb
- 14: Drehantrieb
- 15: Positionierachse
- 16: Vertikalantrieb
- 17: Kamera
- 18: Hubeinrichtung
- 19: Führung
- 20: Abstandshalter
- 21: Maskenrahmen

## Patentansprüche

1. Verfahren zum Anordnen/Entfernen und Ausrichten von Masken auf zu beschichtenden Substraten, insbesondere zur Mikrostrukturierung von organischen elektrolumineszierenden Materialien (OLED) auf großflächigen Substraten, wie Bildschirmen, Displays und dgl. im Vakuum, wobei die Substrate zur Beschichtung durch eine Vakuumbeschichtungsanlage bewegt werden, umfassend:
Bereitstellung eines Substrats (3) auf einem Substratträger (2), an dem an der Rückseite Magnete (4) umlaufend um den Substrataufnahmebereich angeordnet sind,
Halterung der Maske (6) durch Elektromagnete (7) an einer mittels einer ersten Bewegungseinrichtung (5) mehrdimensional verfahrbaren Halteanordnung (8),
Ermitteln der relativen Position von Maske (6) und Substrat (3) zueinander,
Ausrichten von Substrat (3) und Maske (6) zueinander durch Betätigung der ersten Bewegungseinrichtung (5), so dass die Maske (6) relativ zum Substrat bewegt wird, falls eine Fehlorientierung festgestellt worden ist,
Ablage der Maske (6) auf dem Substrat durch Bewegung der Halteanordnung (8) mittels der ersten Bewegungseinrichtung, so dass die Maske nahezu senkrecht zum Substrat (3) bewegt wird, und/oder Bewegung des Substratträgers (2) in Richtung der Maske (6) mittels einer zweiten Bewegungseinrichtung (18),
Deaktivieren der Elektromagnete (7) und
Halterung der Maske (6) auf dem Substrat (3) durch die Magnete (4) des Substratträgers.

2. Verfahren nach Anspruch 1,
**dadurch gekennzeichnet, dass**
eine Maske (6) verwendet wird, die einen magnetischen Rand oder Rahmen (21) aufweist, der mit den Magneten des Substratträgers und der Halteanordnung korrespondiert.

3. Verfahren nach Anspruch 1 oder 2,
**dadurch gekennzeichnet, dass**
die Position der Maske über dem Substrat durch eine Überwachungseinrichtung automatisch, insbesondere mittels einer oder mehrerer, vorzugsweise zwei CCD-Kameras (15) ermittelt wird.

4. Verfahren nach einem der vorhergehenden Ansprüche,
**dadurch gekennzeichnet, dass**
die Ausrichtung der Maske durch unabhängige Linearbewegungen und/oder Drehbewegungen erfolgt.

5. Verfahren nach einem der vorhergehenden Ansprüche,
**dadurch gekennzeichnet, dass**
das Anordnen der Maske am Substrat durch eine Linearbewegung der Halteanordnung (8) und/oder der zweiten Bewegungseinrichtung (18), insbesondere über einen oder mehrere Spindelantriebe erfolgt.

6. Verfahren nach einem der vorhergehenden Ansprüche,
**dadurch gekennzeichnet, dass**
die Annäherung des Substrats (3) von hinten an die fest gehaltene Maske (6) erfolgt.

7. Verfahren nach einem der vorhergehenden Ansprüche,
**dadurch gekennzeichnet, dass**
das Ermitteln der relativen Position eine Ermittlung der lateralen Position ist und/oder das Ausrichten von Maske und Substrat durch eine nahezu parallele Bewegung der Maske zum Substrat erfolgt.

8. Vorrichtung zum Anordnen/Entfernen und Ausrichten von Masken auf zu beschichtenden Substraten, die zur Beschichtung durch eine Vakuumbeschichtungsanlage bewegt werden, insbesondere zur Mikrostrukturierung von organischen elektrolumineszierenden Materialien (OLED) auf großflächigen Substraten, wie Bildschirmen, Displays und dgl., wobei die Maske (6) magnetisch in Bezug zum zu beschichtenden Substrat (3) gehalten wird, mit einer Halteanordnung zum Aufnehmen und Absetzen der Masken und einer ersten Bewegungseinrichtung zum Bewegen der Halteanordnung in Bezug zum Substrat,
**dadurch gekennzeichnet, dass**
die Halteanordnung schaltbare Elektromagnete (7) umfasst, die beabstandet zueinander umlaufend um einen Zentralbereich angeordnet sind, wobei eine zweite Bewegungseinrichtung (18) vorgesehen ist, die eine Bewegung des Substrats (3) zur Halteanordnung der Maske (6) senkrecht zu den Substrat- und Maskenebenen ermöglicht, wobei ein Substratträger vorgesehen ist, an dessen Rückseite Magneten umlaufend um den Substrataufnahmebereich angeordnet sind.

9. Vorrichtung nach Anspruch 8,
**dadurch gekennzeichnet, dass**
die erste und/oder zweite Bewegungseinrichtung einen Spindelantrieb (17) zur Bewegung der Halteanordnung oder der Maske in Richtung zum Substrat und von diesem weg und/oder umgekehrt umfasst.

10. Vorrichtung nach einem der Ansprüche 8 bis 9,
**dadurch gekennzeichnet, dass**
die erste Bewegungseinrichtung mindestens zwei unabhängige Linearantriebe (12,16) und/oder mindestens einen Drehantrieb (14) zur lateralen Ausrichtung der Halteanordnung (8) oder der Maske (6) umfasst.

11. Vorrichtung nach einem der Ansprüche 8 bis 10,
**dadurch gekennzeichnet, dass**
eine Überwachungs- und Steuereinrichtung zur insbesondere lateralen Ausrichtung der Maske zum Substrat vorgesehen ist, die vorzugsweise eine oder mehrere, insbesondere zwei CCD-Kameras (17) umfasst.

12. Vorrichtung nach einem der Ansprüche 8 bis 11,
**dadurch gekennzeichnet, dass**
die Vorrichtung insbesondere mit einer Montagewand (1) derart hergerichtet ist, dass sie in einer Vakuumkammer, insbesondere an einer Kammerwand anordenbar ist.

13. Vorrichtung nach einem der Ansprüche 8 bis 12,
**dadurch gekennzeichnet, dass**
eine Substratträgerhalteposition vorgesehen ist, in der ein Substratträger (2) zum Halten und Transportieren des Substrats durch eine Beschichtungsanlage in einer vordefinierten Übergabeposition zur Halteanordnung anordenbar ist.

14. Vorrichtung nach Anspruch 13
**dadurch gekennzeichnet, dass**
die Substratträgerhalteposition so ausgestaltet ist, dass der Substratträger mit den an ihm angeordneten Magneten (4) gegenüberliegend den Elektromagneten (7) der Halteanordnung, insbesondere deckungsgleich zu liegen kommt.

15. Vorrichtung nach einem der Ansprüche 8 bis 14 ,
**dadurch gekennzeichnet, dass**
die Magnete (4) des Substratträgers und die Elektromagnete (7) der Halteanordnung so aufeinander abgestimmt sind, dass durch An- und Abschalten der Elektromagnete ein Absetzen und Entfernen der Maske vom Substratträger sowie eine feste Halterung der Maske auf dem Substratträger möglich sind.

16. Vorrichtung nach einem der Ansprüche 8 bis 15 ,
**dadurch gekennzeichnet, dass**
die Halteanordnung eine Halteplatte (8) oder einen rechteckigen, mehreckigen oder ringförmigen Halterahmen umfasst, an dem an einer Seite die Elektromagneten und auf der gegenüberliegenden Seite die Antriebe oder Bewegungsmittel der ersten Bewegungseinrichtung vorgesehen sind.

17. Vorrichtung nach einem der Ansprüche 8 bis 16,
**dadurch gekennzeichnet, dass**
die Magnete (4) des Substratträgers äquidistant beabstandet zueinander angeordnet sind.

18. Vorrichtung nach einem der Ansprüche 8 bis 17,
**dadurch gekennzeichnet, dass**
die zweite Bewegungseinrichtung (18) mindestens ein Kopplungselement (11) zum lösbaren Greifen des Substratträgers (2) umfasst.

19. Vorrichtung nach einem der Ansprüche 8 bis 18,
**dadurch gekennzeichnet, dass**
die zweite Bewegungseinrichtung (18) mehrere, vorzugsweise vier Bewegungsmittel, insbesondere Hubeinrichtungen umfasst.

## Claims

1. Method for arranging/removing and aligning masks on substrates to be coated, particularly for micro-structuring of organic electroluminescent materials (OLEDs) on large-area substrates, such as screens, displays and the like in a vacuum, wherein the substrates for coating are moved through a vacuum-coating installation comprising:
provision of a substrate (3) on a substrate carrier (2), all around the substrate-receiver area on the back of which are arranged magnets (4),
holding of the mask (6) by electromagnets (7) at a holding arrangement (8) that can be moved in multiple dimensions by means of a first movement device (5), determination of the relative position of mask (6) and substrate (3) to each other,
aligning of substrate (3) and mask (6) with one another by actuation of the first movement device (5), such that the mask (6) is moved relative to the substrate if a wrong orientation has been identified,
placement of the mask (6) on the substrate through movement of the holding arrangement (8) by means of the first movement device, such that the mask is moved almost perpendicularly to the substrate (3), and/or movement of the substrate carrier (2) in the direction of the mask (6) by means of a second movement device (18),
deactivation of the electromagnets (7) and
holding of the mask (6) on the substrate (3) by the magnets (4) of the substrate carrier.

2. Method in accordance with claim 1,
**characterised by the fact**
that a mask (6) is used which has a magnetic edge or frame (21), which corresponds to the magnets of the substrate carrier and the holding arrangement.

3. Method in accordance with claims 1 or 2,
**characterised by the fact**
that the position of the mask over the substrate is determined automatically by a monitoring device, especially by means of one or more, preferably two, CCD cameras (15).

4. Method of any of the previous claims
**characterised by the fact that**
alignment of the mask proceeds by means of independent linear movements and/or rotary movements.

5. Method of any of the previous claims,
**characterised by the fact that**
arranging of the mask on the substrate proceeds by means of a linear movement of the holding arrangement (8) and/or the second movement device (18), especially via one or more spindle drives.

6. Method of any of the previous claims
**characterised by the fact that**
approaching of the substrate (3) to the fixed-in-placed mask (6) proceeds from the rear.

7. Method of any of the previous claims,
**characterised by the fact that**
the determination of the relative position is a determination of the lateral position, and/or the alignment of mask and substrate proceeds by means of an almost parallel movement of the mask towards the substrate.

8. Device for arranging/removing and aligning masks on substrates to be coated, which are moved through a vacuum-coating installation for the purpose of being coated, especially for the purpose of micro-structuring organic electroluminescent materials (OLEDs) on large-area substrates, such as screens, displays and the like, wherein the mask (6) is held magnetically relative to the substrate to be coated (3), with a holding arrangement for receiving and placing the masks and a first movement device for moving the holding arrangement relative to the substrate
**characterised by the fact that**
the holding arrangement comprises switchable electromagnets (7) that are spaced apart from each other all around a central area, wherein a second movement device (18) is provided, which facilitates a movement of the substrate (3) towards the holding arrangement of the mask (6), perpendicular to the substrate and mask planes, wherein a substrate carrier is provided, at the rear of which magnets are arranged all around the substrate-receiver area.

9. Device of claim 8,
**characterised by the fact that**
the first and/or second movement device comprises a spindle drive (17) for movement of the holding arrangement or the mask towards and away from the substrate and/or vice versa.

10. Device of any of claims 8 to 9,
**characterised by the fact that**
the first movement device comprises at least two independent linear drives (12, 16) and/or at least one rotary drive (14) for lateral alignment of the holding arrangement (8) or the mask (6).

11. Device of any of claims 8 to 10
**characterised by the fact that**
a monitoring and control device is provided especially for lateral alignment of the mask with the substrate, which preferably comprises one or more, especially two, CCD cameras (17).

12. Device of any of claims 8 to 11,
**characterised by the fact that**
the device is especially furnished with an assembly wall (1) such that it can be arranged in a vacuum chamber, especially at a chamber wall.

13. Device of any of claims 8 to 12,
**characterised by the fact that**
a substrate-carrier holding position is provided in which can be arranged a substrate carrier (2) for holding and transporting the substrate through a coating installation in a pre-defined handover position to the holding arrangement.

14. Device of claim 13
**characterised by the fact that**
the substrate-carrier holding position is configured such that the substrate carrier with the magnets (4) arranged thereon comes to rest opposite the electromagnets (7) of the holding arrangement, especially in a congruent fashion.

15. Device of any of claims 8 to 14,
**characterised by the fact that**
the magnets (4) of the substrate carrier and the electromagnets (7) of the holding arrangement are matched to each other such that, by means of switching the electromagnets on and off, placement and removal of the mask on and from the substrate carrier and firm holding of the mask on the substrate carrier are possible.

16. Device of any of claims 8 to 15,
**characterised the fact that**
the holding arrangement comprises a holding plate (8) or a rectangular, polygonal or annular holding frame, on one side of which the electromagnets and on the opposite side of which the drives or means of movement of the first movement device are provided.

17. Device in accordance with any of claims 8 to 16,
**characterised by the fact that**
the magnets (4) of the substrate carrier are spaced equidistantly apart from each other.

18. Device of any of claims 8 to 17,
**characterised by the fact that**
the second movement device (18) comprises at least one coupling element (11) for detachable gripping of the substrate carrier (2).

19. Device of any of claims 8 to 18,
**characterised by the fact that**
the second movement device (18) comprises several, preferably four means of movement, especially lifting devices.

## Revendications

1. Procédé pour disposer/retirer et aligner des masques sur des substrats à revêtir, notamment pour la microstructuration de matériaux électroluminescents organiques (OLED) sur des substrats de grande surface, tels que des écrans et leur équivalent sous vide, les substrats étant déplacés par une installation de revêtement sous vide pour leur revêtement, ledit procédé comprenant :
la préparation d'un substrat (3) sur un support de substrat (2) sur la face arrière duquel sont disposés des aimants (4) de façon circonférentielle autour de la zone de réception de substrat ;
le maintien du masque (6) à l'aide d'électroaimants (7) au niveau d'une installation de maintien (8) déplaçable dans plusieurs dimensions à l'aide d'un premier dispositif de déplacement (5) ;
la détermination de la position relative du masque (6) et du substrat (3) l'un par rapport à l'autre ;
le alignement du substrat (3) et du masque (6) l'un par rapport à l'autre par actionnement du premier dispositif de déplacement (5), de sorte que le masque (6) peut être déplacé par rapport au substrat si un constat d'erreur d'orientation est dressé ;
la pose du masque (6) sur le substrat par déplacement de l'installation de maintien (8) à l'aide du premier dispositif de déplacement, de sorte que le masque est déplacé presque perpendiculairement au substrat (3), et/ou le déplacement du support de substrat (2) en direction du masque (6) à l'aide d'un deuxième dispositif de déplacement (18) ;
la désactivation des électroaimants (7) ; et
le maintien du masque (6) sur le substrat (3) au moyen des aimants (4) du support de substrat.

2. Procédé selon la revendication 1, **caractérisé en ce qu'**on utilise un masque (6) comportant un bord ou un cadre (21) magnétique correspondant aux aimants du support de substrat et de l'installation de maintien.

3. Procédé selon la revendication 1 ou 2, **caractérisé en ce que** la position du masque au-dessus du substrat est déterminée automatiquement par un dispositif de surveillance, notamment à l'aide d'une ou de plusieurs, de préférence de deux caméras à dispositif à transfert de charge CCD (15).

4. Procédé selon l'une quelconque des revendications précédentes, **caractérisé en ce que** le alignement du masque est réalisé par des mouvements linéaires et/ou des mouvements de rotation indépendants.

5. Procédé selon l'une quelconque des revendications précédentes, **caractérisé en ce que** la disposition du masque contre le substrat est réalisée au moyen d'un mouvement linéaire de l'installation de maintien (8) et/ou du deuxième dispositif de déplacement (18), notamment via un ou plusieurs entraînements à broche.

6. Procédé selon l'une quelconque des revendications précédentes, **caractérisé en ce que** l'approche du substrat (3) se produit depuis l'arrière au niveau du masque (6) maintenu fixement.

7. Procédé selon l'une quelconque des revendications précédentes, **caractérisé en ce que** la détermination de la position relative est un calcul de la position latérale et/ou que le alignement du masque et du substrat est réalisé au moyen d'un mouvement presque parallèle du masque par rapport au substrat.

8. Appareil pour disposer/retirer et aligner des masques sur des substrats à revêtir, lesdits substrats étant déplacés pour leur revêtement au moyen d'une installation de revêtement sous vide, notamment pour la microstructuration de matériaux électroluminescents organiques (OLED) sur des substrats de grande surface, tels que des écrans et leur équivalent, le masque (6) étant maintenu de façon magnétique par rapport au substrat (3) à revêtir, avec une installation de maintien pour recevoir et déposer les masques et avec un premier dispositif de déplacement pour déplacer l'installation de maintien par rapport au substrat, **caractérisé en ce que** l'installation de maintien comprend des électroaimants (7) commutables disposés à une certaine distance les uns des autres de façon circonférentielle autour d'une zone centrale, un deuxième dispositif de déplacement (18) étant prévu et permettant un déplacement du substrat (3) par rapport à l'installation de maintien du masque (6) perpendiculairement aux plans du substrat et des masques, un support de substrat étant prévu au niveau de la face arrière duquel des aimants sont disposés de façon circonférentielle autour de la zone de réception de substrat.

9. Appareil selon la revendication 8, **caractérisé en ce que** le premier et/ou le deuxième dispositif de déplacement comprend un entraînement à broche (17) pour déplacer l'installation de maintien ou le masque en direction du substrat puis pour l'en éloigner et/ou inversement.

10. Appareil selon l'une quelconque des revendications 8 à 9, **caractérisé en ce que** le premier dispositif de déplacement comprend au moins deux entraînements linéaires (12, 16) indépendants et/ou au moins un entraînement en rotation (14) pour le alignement latéral de l'installation de maintien (8) ou du masque (6).

11. Appareil selon l'une quelconque des revendications 8 à 10, **caractérisé en ce qu'**un dispositif de surveillance et de commande est prévu, notamment pour le alignement latéral du masque par rapport au substrat, ledit dispositif comprenant de préférence une ou plusieurs, notamment deux caméras à dispositif à transfert de charge CCD (17).

12. Appareil selon l'une quelconque des revendications 8 à 11, **caractérisé en ce que** l'appareil est notamment réalisé avec une paroi de montage (1) permettant un placement dans une chambre sous vide, notamment contre une paroi de la chambre.

13. Appareil selon l'une quelconque des revendications 8 à 12, **caractérisé en ce qu'**une position de maintien de support de substrat est prévue dans laquelle un support de substrat (2) peut être disposé dans une position de transfert prédéfinie par rapport à l'installation de maintien pour maintenir le substrat et le transporter à travers une installation de revêtement.

14. Appareil selon la revendication 13, **caractérisé en ce que** la position de maintien du support de substrat est configurée de telle sorte que le support de substrat repose avec les aimants (4) disposés contre lui à l'opposée des électroaimants (7) de l'installation de maintien, notamment comme un cache.

15. Appareil selon l'une quelconque des revendications 8 à 14, **caractérisé en ce que** les aimants (4) du support de substrat et les électroaimants (7) de l'installation de maintien sont réglés de telle sorte l'un par rapport à l'autre qu'une dépose et un retrait du masque hors du support de substrat est possible ainsi qu'un maintien fixe du masque sur le support de substrat suivant si les électroaimants sont connectés ou déconnectés.

16. Appareil selon l'une quelconque des revendications 8 à 15 , **caractérisé en ce que** l'installation de maintien comprend une plaque de maintien (8) ou un cadre de support rectangulaire, polygonal ou annulaire sur lequel des électroaimants sont prévus sur un côté et sur lequel des entraînements ou des moyens de déplacement du premier dispositif de déplacement sont prévus sur le côté opposé.

17. Appareil selon l'une quelconque des revendications 8 à 16, **caractérisé en ce que** les aimants (4) du support de substrat sont disposés de façon équidistante les uns par rapport aux autres.

18. Appareil selon l'une quelconque des revendications 8 à 17, **caractérisé en ce que** le deuxième dispositif de déplacement (18) comprend au moins un élément de couplage (11) pour se saisir de façon détachable du support de substrat (2).

19. Appareil selon l'une quelconque des revendications 8 à 18, **caractérisé en ce que** le deuxième dispositif de déplacement (18) comprend plusieurs, de préférence quatre moyens de déplacement, notamment des dispositifs de levage.
